# EUROPEAN PATENT APPLICATION

(11) **EP 0 933 214 A2**
(43) Date of publication of application: **04.08.1999**
(21) Application number: 98121909.0
(22) Date of filing: 18.11.1998
(51) Int. Cl.: B41J 2/06

(54) **A method of and apparatus for directing ink towards substrate**

(30) Priority: 30.01.1998 GB 9802090
(71) Applicant: H. Bollmann Manufacturers Ltd., West Sussex, RH15 9NF (GB)
(72) Inventor: Mould, David Frederick, Burgess Hill, RH15 9ST (GB); Bollmann, Klaus, East Sussex BN7 3BD (GB)
(74) Representative: Frankland, Nigel Howard

(57) **Abstract**

A method of directing ink onto a substrate comprises the steps of locating a drop of ink in a predetermined position relative to the substrate, applying a predetermined electric potential to the drop of ink and generating an electrostatic field to accelerate the drop of ink and to direct the drop of ink onto the substrate.

## Description

The present invention relates to a method of and apparatus for directing ink towards a substrate. The invention also relates to a method of making the apparatus for directing ink towards a substrate.

In recent years it has become common-place to effect printing using an ink jet printing technique. In utilising the ink jet printing technique, droplets of ink are discharged on to a recording medium, such as a sheet of paper, with the droplets being caused to impact upon the paper at appropriate predetermined position. Typically, the recording medium, such as a sheet of paper, is passed through a printing machine, and passes adjacent a print head. The print head discharges droplets of ink which impact the recording medium at precisely predetermined positions, thus providing the desired printing effect.

In prior proposed ink jet printing devices, the ink jet has been generated either by heating the ink, which causes a droplet of ink to be ejected from a nozzle, or by using a piezo electric device to discharge a droplet of ink.

These prior arrangements are relatively expensive to manufacture, and the present invention seeks to provide a method of directing ink towards a substrate, and an apparatus for effecting the method, in which the apparatus may be manufactured relatively simply and relatively cheaply, whilst still providing an appropriate performance.

According to this invention there is provided a method of directing ink on to a substrate, the method comprising steps of locating the substrate in a predetermined position, locating a drop of ink in a second predetermined position, applying a predetermined potential to the drop of ink, and generating an electro-static field to accelerate the drop of ink and to direct the drop of ink on to the substrate.

Preferably the method comprises the steps of locating a drop of ink in contact with an electrode, and applying a substantial potential to the electrode, the drop of ink being repelled from the electrode by electro-static repulsion.

Conveniently the electrode is located in a recess, the drop of ink being located in contact with the electrode by applying a potential to an annular conductive element defining the lip of the recess to attract ink electro-statically from a reservoir to the annular conductive element, and subsequently reversing the polarity applied to the annular conductive element.

Advantageously the substrate comprises paper, and the method comprises the steps of moving the substrate passed the said electrode and applying said potential to said electrode under the control of a controller.

The invention also relates to an apparatus for performing the method as described above the apparatus comprising a substrate, at least one electrode carried by the substrate, electrode being located in a recess formed in an insulating layer, the lip of the recess being defined by a conductive element, the upper surface of the insulating layer adjacent the recess being positioned to receive ink from an ink reservoir.

Preferably the upper surface of the insulating layer is provided with porous means defining the ink reservoir.

Conveniently a conductive layer is provided on the upper part of the porous layer.

Preferably the plurality of said electrodes are provided in the form of a substantially regular array.

The invention also relates to a method of making an apparatus as described above, the method comprising the steps of forming a plurality of electrodes on a substrate, subsequently forming an insulating layer on the substrate with recesses therein, each recess accommodating an electrode, and forming a conductive element at the lip of each recess.

Preferably the method comprises the additional step of providing a porous ink reservoir on the upper part of the insulating layer, with the ink reservoir being provided with electrically conductive means in the upper region thereof.

The invention also relates to a printing apparatus comprising a print head, said print head comprising an apparatus as described above, means being provided for effecting a predetermined relative movement between the print head and an ink-receiving medium.

In order that the invention may be more readily understood, and so that further features thereof may be appreciated, the invention will now be described, by way of example, with reference to the accompanying drawings in which
FIGURE 1 is a perspective view of a substrate during an initial stage in the manufacture of a printing head for use in the invention,
FIGURE 2 is an enlarged view of part of the substrate during the subsequent stage in the manufacture process,
FIGURE 3 is a sectional and perspective view of part of the substrate during a further stage in the manufacturing process,
FIGURE 4 is a corresponding sectional and perspective view, on an enlarged scale, at the end of the manufacturing process,
FIGURE 5 is a view combining a perspective sectional view of part of the apparatus, and a graphical representation showing potentials applied to various parts of the apparatus and the times at which those potentials are applied,
FIGURE 6 comprises five views of part of the apparatus shown in Figures 4 and 5 at different points in time,
FIGURE 7 is a diagrammatic view, corresponding to Figure 4, illustrating an alternative embodiment of the invention, and
FIGURE 8 is a diagrammatic view illustrating components of a printing apparatus incorporating a printing head of the type illustrated in Figures 1 to 4.

The invention relates to a method of directing ink towards a substrate, and an apparatus for performing a method in which initially an ink drop is generated and located at a predetermined position in contact with the electrode, and a potential is applied to the electrode, thus imparting an electro-static charge to the drop of ink, and creating an electro-static field which causes the drop of ink to be moved away from the electrode. An appropriate substrate is located in position so that the drop of ink impinges on the substrate at an appropriate position. The invention also relates to an apparatus for effecting printing which incorporates an appropriate print head.

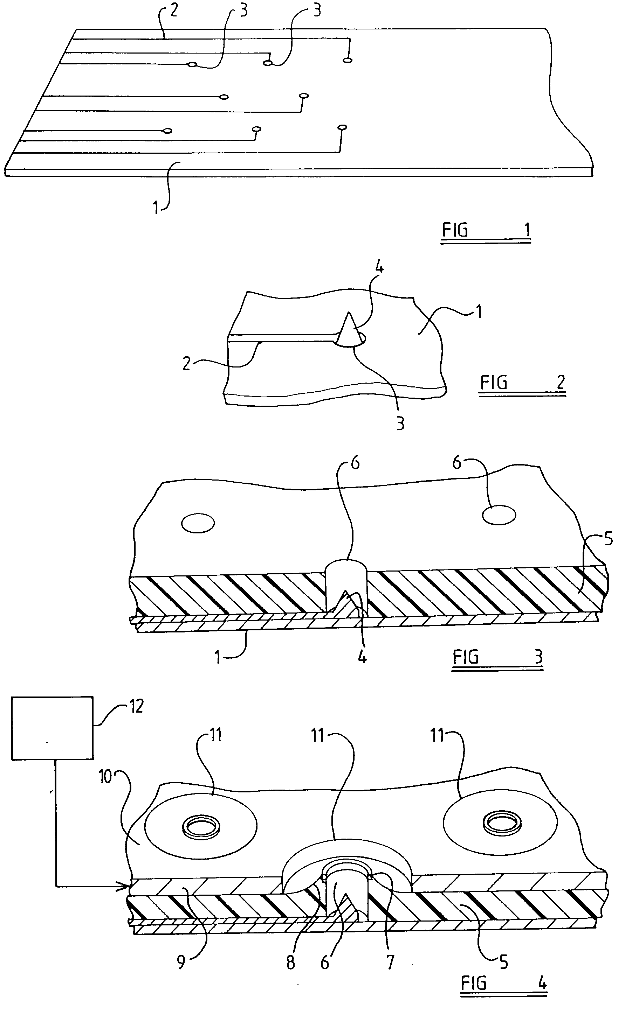

Figure 1 illustrates a substrate 1 which may be a typical substrate as used for a printed circuit board. A plurality of tracks 2 are formed on the printed circuit board, each track terminating at an enlarged terminal area 3. Although only a few terminal areas 3 are illustrated in Figure 1, it is to be appreciated that a substantially regular array of terminal areas 3 will be present on a substrate for use in forming an embodiment of the invention.

Figure 2 illustrates a part of the substrate 1 of Figure 1 at a subsequent stage during the manufacturing process. A substantially conical electrode 4 has been formed on each terminal area 3.

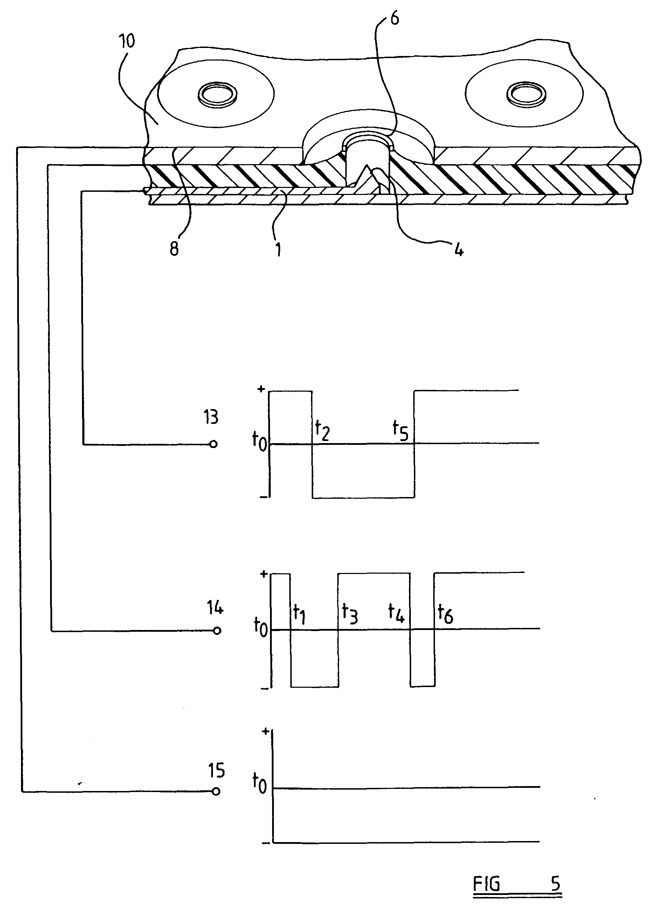

Figure 3 illustrates a further subsequent stage during the manufacturing process. A layer of resistive material 5 has been deposited on top of the substrate 1, and recesses 6 have been formed in the insulating layer 5, exposing the conical electrodes 4.

Figure 4 illustrates a further subsequent stage during the manufacturing process.

A ring of conductive material 7 has been provided which surrounds the upper lip of each recess 6. The resistive material around each recess 6 has been etched away, so that each recess 6 is surrounded by a downwardly sloping frusto-conical region 8. The upper surface of this frusto-conical region 8 has been made to be porous, and a layer 9 of porous material has been provided on top of the planar upper surface of the insulating layer 5 surrounding the frusto-conical regions 8. A metallic electrode 10 has been mounted in position on top of the porous layer 9. A signal track leads to each ring of conductive material 7.

As can be seen, the porous layer 9 is provided with relatively large recesses 11 which effectively surround the recesses 6.

It is envisaged that the complete substrate, which constitutes a print head when the various described manufacturing processes have been completed, will be connected to an ink reservoir 12 which is adapted to supply ink to the porous layer 9.

Referring now to Figure 5, in use of the print head the signal track 1 is connected to a first source of potential 13 and the signal track 8, which is associated with the ring of conductive material 7, is connected to a second source of potential 14 whilst the metallic electrode 10, located on top of the porous layer 9, is connected to a third source of potential 15.

At the beginning of a cycle of operation, that is to say at time t₀, a high positive potential is applied to the signal track 1 associated with the electrode 4, a high positive potential is applied to the signal track associated with the ring of conductive material 7, and a high negative potential is applied to the electrically conducting layer 10.

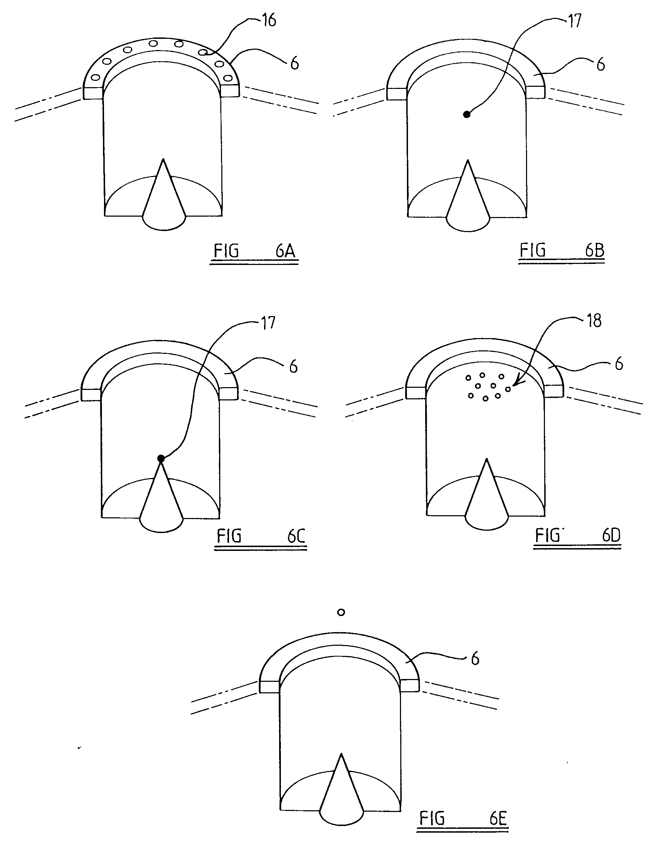

Ink present within the porous layer 9 will be provided with a high negative charge as a consequence of potential applied to the metallic electrode 10. The ink will thus be electro-statically attracted towards the ring of conductive material 7 which carries a high positive potential. The ink will thus flow up the frusto-conical region 8, which is made of porous material, until a plurality of very small droplets of ink 16 are present on the ring of conductive material 7 as shown in Figure 6A.

At the instant of time t₁, the high positive potential applied to the ring of conductive material 7 is reversed and becomes a high negative potential. The small droplets of ink 16, which carry a positive charge, are repelled by the negative charge now applied to the ring of conductive material 7 to form a single droplet 17 located substantially centrally within the recess 6. The droplet is attracted towards the electrode 4, which still carries a high positive potential. As the droplet is attracted towards the electrode 4, the polarity applied to the electrode 4 is reversed to be a positive potential at instant t₃. Subsequently the ink drop 17 contacts the electrode 4 as shown in Figure 6C. The high negative potential applied to the electrode 4 is transferred to the ink drop 17 which is repelled from the electrode 4. The ink drop 17 is accelerated by the electro-static field established by the potential applied to the electrode 4. As the ink drop travels away from the electrode 4 the ink drop may fragment to form a plurality of very small droplets 18 as shown in Figure 6C. At the instant t₄ these droplets approach the ring of conductive material 7, the polarity applied to the ring 7 is reversed so that the ring 7 carries a very high negative potential. The small droplets have a negative potential and the ring 7 carries a negative potential and consequently, a focusing effect is achieved, with the droplets coalescing to form a single droplet 18 which is ejected from the recess. As the droplet passes through the ring 7, at instant t₅, the polarity applied to the potential electrode 4 may be reversed and thus, at instant t₆ the polarity of the potential applied to the ring 7 may be reversed, so that the apparatus is again in the initial condition.

It is to be appreciated that the substrate with the various electrodes and insulating porous layers may all be fabricated using a series of steps involving the use of photo-lithographically produced masks, etching steps, treatment steps and metal deposition steps or further deposition steps. Consequently, an array of recesses can be reliably and relatively economically manufactured, each recess being adapted to eject a drop of ink at an appropriate instant.

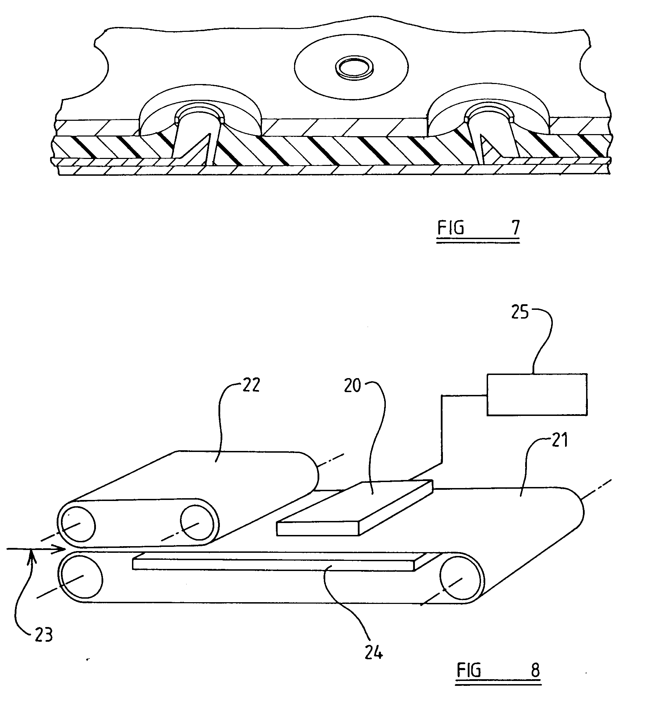

Figure 7 illustrates a modified embodiment of the invention in which two recesses and associated electrodes are illustrated, the recesses and electrodes being generally of the same design as described above.

However, in the arrangement shown in Figure 7, the recesses are inclined to an axis which is perpendicular to the plane of the substrate. Consequently, these recesses eject ink droplets which do not travel perpendicularly to the substrate, but instead travel at an angle to the perpendicular. This facilitates the concentration of droplets at a single point on a substrate.

Figure 8 illustrates, schematically, components of a printing apparatus. A printing head 20 is located in position above a conveyor 21. A further conveyor 22 is located above the conveyor 21 to co-operate with the conveyor 21 to grip a sheet of paper to cause the sheet of paper to travel in the direction indicated by the arrow 23, between the conveyor 22 and the conveyor 21 with the paper continuing to move across the top of the conveyor 21 beneath the printing head 20. On the side of the conveyor 21 remote from the printing head 20 is provided a metal plate 24, which may be provided with a substantially electric potential. The paper will be biased to engage the conveyor 21 due to the electro-static attraction from the plate 24.

The printing head 20 is in the inverted condition as compared with the substrate as illustrated above. The printing head 20 will eject ink downwardly on to the sheet of paper under the control of an appropriate driver, such as a driver 25.

The ink supplied from the ink reservoir 12 to the porous material 9 may be a conventional ink, but in a modified embodiment of the invention may be an ink that has a high melting point. Means will be provided to heat the porous material 9 when the printer is to be used in order to melt the ink to enable the ink to be drawn, by electro-static attraction, to the described recesses 6.

## Claims

1. A method of directing ink on to a substrate, the method comprising steps of locating the substrate in a predetermined position, locating a drop of ink in a second predetermined position, applying a predetermined potential to the drop of ink, and generating an electro-static field to accelerate the drop of ink and to direct the drop of ink on to the substrate.

2. A method according to Claim 1 wherein the method comprises the steps of locating a drop of ink in contact with an electrode, and applying a substantial potential to the electrode, the drop of ink being repelled from the electrode by electro-static repulsion.

3. A method according to Claim 2 wherein the electrode is located in a recess, the drop of ink being located in contact with the electrode by applying a potential to an annular conductive element defining the lip of the recess to attract ink electro-statically from a reservoir to the annular conductive element, and subsequently reversing the polarity applied to the annular conductive element.

4. A method according to any one of the preceding Claims wherein the substrate comprises paper, and the method comprises the steps of moving the substrate passed the said electrode and applying said potential to said electrode under the control of a controller.

5. An apparatus for performing the method of any one of the preceding Claims, the apparatus comprising a substrate, at least one electrode carried by the substrate, electrode being located in a recess formed in an insulating layer, the lip of the recess being defined by a conductive element, the upper surface of the insulating layer adjacent the recess being positioned to receive ink from an ink reservoir.

6. An apparatus according to Claim 5 wherein the upper surface of the insulating layer is provided with porous means defining the ink reservoir.

7. An apparatus according to Claim 6 wherein a conductive layer is provided on the upper part of the porous layer.

8. An apparatus according to any one of Claims 5 to 7 wherein the plurality of said electrodes are provided in the form of a substantially regular array.

9. A method of making an apparatus according to any one of Claims 5 to 8, the method comprising the steps of forming a plurality of electrodes on a substrate, subsequently forming an insulating layer on the substrate with recesses therein, each recess accommodating an electrode, and forming a conductive element at the lip of each recess.

10. A method according to Claim 7 comprising the additional step of providing a porous ink reservoir on the upper part of the insulating layer, with the ink reservoir being provided with electrically conductive means in the upper region thereof.

11. A printing apparatus comprising a print head, said print head comprising an apparatus according to any one of Claims 5 to 8, means being provided for effecting a predetermined relative movement between the print head and an ink-receiving medium.
